# FASCICULE DE BREVET EUROPEEN

(11) **EP 3 978 940 B1**
(45) Date de publication et mention de la délivrance du brevet: **12.07.2023**
(21) Numéro de dépôt: 21199687.1
(22) Date de dépôt: 29.09.2021
(51) Int. Cl.: G01R 31/50, G01R 19/00, G01R 19/165, H02H 1/06, H02H 3/04, H02H 3/08

(54) **MÉTHODES ET SYSTÈMES POUR IDENTIFIER UN CAPTEUR DE COURANT DÉFAILLANT**
METHODEN UND SYSTEME ZUR IDENTIFIZIERUNG EINES DEFEKTEN STROMSENSORS
METHODS AND SYSTEMS FOR IDENTIFYING A FAULTY CURRENT SENSOR

(30) Priorité: 30.09.2020 FR 2009985
(43) Date de publication de la demande: 06.04.2022
(73) Titulaire: Schneider Electric Industries SAS, 92500 Rueil-Malmaison (FR)
(72) Inventeur: BLANCHARD, Pierre, 38340 VOREPPE (FR); BERNARD, Jean-Baptiste, 38180 SEYSSINS (FR); SICARD, Stephane, 38220 SAINT JEAN DE VAULX (FR)
(74) Mandataire: Lavoix

(56) Documents cités:
- DE-A1- 3 223 687
- US-A- 6 141 198
- US-A1- 2011 025 515
- US-A1- 2011 234 255
- US-A1- 2020 191 841

## Description

L'invention se rapporte à des méthodes et des systèmes pour identifier un capteur de courant défaillant dans un appareil électrique.

L'invention se rapporte plus particulièrement au domaine des appareils de protection électrique et/ou des appareils de mesure électrique, tels ceux utilisés dans des installations de distribution d'électricité, notamment dans des installations servant à distribuer un courant électrique alternatif.

De tels appareils électriques sont généralement associés à un ou plusieurs conducteurs de phase de l'installation électrique, par exemple pour être en mesure d'interrompre la circulation du courant électrique dans ces conducteurs de phase en cas d'apparition d'un défaut électrique. Les exemples de l'art antérieur concernant la détection de défaut peuvent être vus dans US 6 141 198 A, US 2011/234255 A1, US 2020/191841 A1, US 2011/025515 A1 et DE 32 23 687 A1.

De façon connue, certains de ces appareils peuvent être, au moins en partie, alimentés électriquement par du courant circulant dans les conducteurs de phase. Ces appareils sont dits être autoalimentés. Le courant électrique nécessaire au fonctionnement de l'appareil électrique peut, par exemple, être prélevé par l'intermédiaire de capteurs de courant, tels que des transformateurs de courant montés autour de chacun des conducteurs de phase. Ainsi, l'appareil n'a pas besoin d'être alimenté électriquement par une ligne d'alimentation électrique dédiée ou par une batterie embarquée. Il n'est pas non plus nécessaire de créer une connexion électrique directe entre les conducteurs de phase et l'appareil électrique.

Cela simplifie considérablement la fabrication de l'appareil ainsi que son montage dans l'installation électrique.

Ces appareils autoalimentés ont pour inconvénient qu'en cas de défaillance d'un des capteurs de courant, l'appareil court le risque de ne plus être alimenté correctement, ce qui peut compromettre son bon fonctionnement et peut poser un problème de sécurité inacceptable.

C'est à ces inconvénients qu'entend plus particulièrement remédier l'invention en proposant des dispositifs et des procédés pour identifier un capteur de courant défaillant dans un appareil électrique, notamment dans un appareil de protection électrique.

A cet effet, un aspect de l'invention concerne un procédé pour identifier un capteur de courant défaillant dans un appareil électrique, dans lequel l'alimentation électrique de l'appareil électrique est au moins en partie fournie par un circuit d'alimentation électrique à découpage connecté à au moins un capteur de courant qui prélève un courant électrique dans un conducteur de phase d'une installation électrique, le circuit d'alimentation délivrant une tension électrique régulée, dans lequel le procédé comporte des étapes consistant à :
déterminer un rapport cyclique de commutation d'un interrupteur de puissance de l'alimentation électrique à découpage ;
analyser le rapport cyclique de commutation déterminé ;
identifier une condition de défaillance si le comportement du rapport cyclique de commutation est représentatif d'une défaillance d'au moins un des capteurs de courant.

Grâce à l'invention, le dispositif de diagnostic permet de détecter une anomalie de fonctionnement d'un capteur de courant susceptible de compromettre le bon fonctionnement de l'appareil.

Selon des aspects avantageux mais non obligatoires, de telles méthodes et systèmes peuvent incorporer une ou plusieurs des caractéristiques suivantes, prises isolément ou suivant toute combinaison techniquement admissible :
- L'analyse du rapport cyclique de commutation comporte une comparaison du rapport cyclique de commutation déterminé avec une valeur de référence prédéterminée.
- La valeur de référence prédéterminée est choisie en fonction de l'amplitude du courant circulant dans les conducteurs de phase.
- L'analyse du rapport cyclique de commutation comporte une analyse de l'évolution du rapport cyclique au cours du temps par rapport à un historique de valeurs passées.
- L'analyse de l'évolution au cours du temps est effectuée au moyen d'un filtre à réponse impulsionnelle infinie.
- L'analyse du rapport cyclique de commutation comporte une comparaison du rapport cyclique de commutation déterminé avec une valeur théorique du rapport cyclique de comparaison calculée à partir de valeurs de courant mesurées à l'aide d'un ou de plusieurs capteurs de courant additionnels.
- Le rapport cyclique déterminé est une valeur moyenne du rapport cyclique de commutation moyennée sur une durée prédéfinie, par exemple sur une durée correspondant à plusieurs périodes du courant circulant dans les conducteurs de phase.
- Une alerte est automatiquement émise si une condition de défaut est identifiée.
- L'appareil électrique est un appareil de protection électrique, tel qu'un disjoncteur, et dans lequel l'appareil est automatiquement déclenché si une condition de défaut est identifiée.
- Le procédé d'identification d'un capteur défaillant comporte, en outre, des étapes consistant à :
   - mesurer la valeur du courant total circulant dans le ou les conducteurs de phase de l'installation électrique, au moyen d'un ou de plusieurs capteurs de courant additionnels ;
   - mesurer le courant total issu dudit au moins un capteur de courant, puis comparer les valeurs de courant total mesuré avec les valeurs de courant mesuré par le ou les capteurs additionnels ;
   - identifier une condition de défaillance si l'écart entre les valeurs de courant total issu dudit au moins un capteur de courant et les valeurs de courant mesuré par le ou les capteurs additionnels est supérieur à un seuil prédéfini.

Selon un autre aspect, l'appareil électrique, comporte :
- au moins un capteur de courant adapté pour prélever un courant électrique dans un conducteur de phase d'une installation électrique, et
- un circuit d'alimentation électrique à découpage connecté auxdits capteurs de courant et étant configuré pour délivrer une tension électrique régulée pour alimenter l'appareil électrique. L'appareil électrique comporte un dispositif de diagnostic configuré pour mettre en oeuvre des étapes consistant à :
- déterminer un rapport cyclique de commutation d'un interrupteur de puissance de l'alimentation électrique à découpage ;
- analyser le rapport cyclique de commutation déterminé ; et à
- identifier une condition de défaillance si le comportement du rapport cyclique de commutation est représentatif d'une défaillance d'au moins un des capteurs de courant.

L'invention sera mieux comprise et d'autres avantages de celle-ci apparaîtront plus clairement à la lumière de la description qui va suivre d'un mode de réalisation d'un appareil électrique de protection ou de mesure donnée uniquement à titre d'exemple et faite en référence aux dessins annexés, dans lesquels :
[Fig 1] la figure 1 est un schéma synoptique simplifié d'un appareil électrique associé à une installation électrique et comportant un dispositif de diagnostic conforme à des modes de réalisation de l'invention ;
[Fig 2] la figure 2 représente schématiquement un mode de réalisation du dispositif de diagnostic de la figure 1 ;
[Fig 3] la figure 3 est un ordinogramme d'un procédé de fonctionnement du dispositif de diagnostic de la figure 1 ;
[Fig 4] la figure 4 est un schéma montrant l'évolution de grandeurs électriques lors du fonctionnement du dispositif de diagnostic de la figure 1 dans des conditions normales ;
[Fig 5] la figure 5 est un schéma montrant l'évolution de grandeurs électriques lors d'une autre phase de fonctionnement du dispositif de diagnostic de la figure 1 ;
[Fig 6] la figure 6 représente schématiquement un autre mode de réalisation du dispositif de diagnostic de la figure 1.

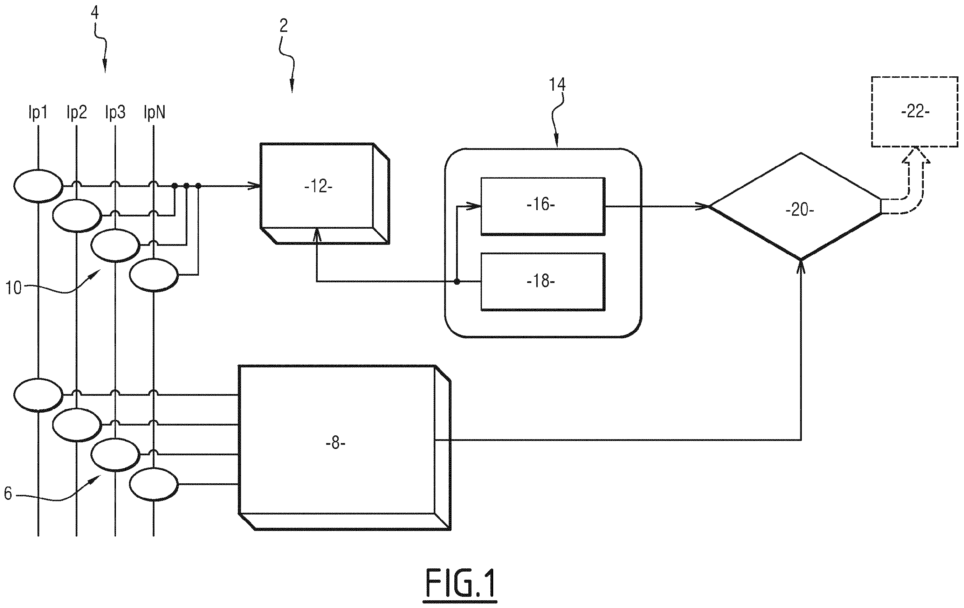

La figure 1 représente un dispositif de diagnostic 2 embarqué dans un appareil électrique (non représenté), tel qu'un appareil de protection électrique ou un appareil électrique de mesure. Par exemple, l'appareil électrique peut être un disjoncteur.

L'appareil électrique est configuré pour être associé à une installation électrique 4, telle qu'une installation de distribution d'électricité.

L'installation électrique comporte un ou plusieurs conducteurs de phase destinés à acheminer un courant électrique alternatif.

Dans l'exemple illustré, l'installation électrique 4 comporte trois conducteurs de phase, notés Ip1, Ip2 et Ip3, pour acheminer un courant électrique triphasé, ainsi qu'un conducteur de neutre, noté IpN, et qui par la suite sera assimilé à un conducteur de phase.

Cet exemple n'est pas limitatif et en variante, le nombre de conducteurs de phase pourrait être différent. Le conducteur de phase associé au neutre IpN pourrait être omis.

L'appareil électrique comporte un premier groupe de capteurs de courant 6, chacun couplé à un conducteur de phase Ip1, Ip2, Ip3 et IpN.

Par exemple, les capteurs de courant 6 sont des tores de mesure, tels que des tores de Rogowski, ou des transformateurs de courant, ou tout autre type de capteur analogue.

Selon un exemple de mise en oeuvre, chaque capteur de courant 6 comporte un tore, pouvant être magnétique ou non-magnétique (comme c'est le cas des tores de Rogowski), entourant le conducteur de phase et une bobine enroulée autour du tore et dont les extrémités opposées forment des bornes de sortie du capteur de courant 6.

Chaque capteur de courant 6 est configuré pour délivrer un courant électrique lorsque le conducteur de phase autour duquel il est monté est traversé par un courant électrique.

Les capteurs de courant 6 sont ici connectés à un circuit électronique de traitement 8, configuré pour analyser les courants mesurés par les capteurs de courant 6.

Par exemple, le circuit électronique de traitement 8 permet à l'appareil de mettre en oeuvre des fonctions de surveillance et de mesure du courant circulant dans l'installation électrique 4.

A titre d'exemple, le circuit électronique de traitement 8 peut être connecté à un déclencheur de l'appareil électrique.

L'appareil électrique comporte également un deuxième groupe de capteurs de courant 10, chacun de ces capteurs de courant 10 étant couplé à un desdits conducteurs de phase Ip1, Ip2, Ip3 et IpN.

Par exemple, les capteurs de courant 10 sont des capteurs basés sur des tores magnétiques (tels des transformateurs de courant) et les capteurs de courant 6 sont des tores de Rogowski.

L'appareil électrique comporte également un circuit d'alimentation à découpage 12 configuré pour délivrer une tension d'alimentation électrique, par la suite nommée « tension de sortie », qui sert à alimenter, au moins en partie, l'appareil électrique à partir du courant électrique issu des capteurs de courant 10.

En d'autres termes, les capteurs de courant 10 permettent d'alimenter l'appareil 2 à partir du courant de ligne circulant dans les conducteurs de phase.

Plus particulièrement, le circuit d'alimentation 12 est configuré au moins pour alimenter des fonctions de mesure et/ou de surveillance et/ou de protection assurées par l'appareil électrique, par exemple en alimentant un déclencheur de l'appareil électrique.

Par exemple, le circuit d'alimentation électrique 12 peut comporter un convertisseur de puissance et/ou un circuit de filtrage et/ou un redresseur.

Notamment, le circuit d'alimentation 12 comporte un convertisseur de puissance à découpage configuré pour convertir les tensions alternatives obtenues en sortie des capteurs de courant 10 en une tension électrique régulée, de préférence une tension continue.

Avantageusement, le circuit d'alimentation électrique 12 comporte au moins un interrupteur de puissance, tel qu'un transistor de puissance.

Par exemple, la commutation de cet interrupteur de puissance permet de redresser la tension électrique de sortie, comme on le comprendra à la lecture de ce qui suit.

Dans de nombreux modes de réalisation, le circuit d'alimentation électrique 12 comporte plusieurs tels interrupteurs de puissance.

Dans ce qui suit, par souci de simplification, seul un tel interrupteur de puissance sera décrit. On comprend néanmoins que les modes de réalisation décrits ci-après peuvent être généralisés au cas où le circuit d'alimentation électrique 12 comporte plusieurs tels interrupteurs de puissance.

Le circuit d'alimentation électrique 12 peut également comporter une réserve d'énergie, telle qu'un condensateur, comme expliqué ci-après.

De façon générale, le dispositif de diagnostic 2 est configuré pour identifier une défaillance de l'un des capteurs de courant 10 et/ou une défaillance du circuit d'alimentation 12. Pour cela, le dispositif de diagnostic 2 peut se baser sur les mesures issues des groupes de capteurs de courant 6 et 10.

A cet effet, selon des modes de réalisation illustrés sur le schéma synoptique de la figure 1, le dispositif de diagnostic 2 comporte un deuxième circuit électronique de traitement 14 (aussi nommé circuit de contrôle), qui comporte ici :
- un premier module de traitement 18 configuré pour générer un signal de commande servant à piloter ledit au moins un interrupteur de puissance du circuit d'alimentation électrique 12, et
- un deuxième module de traitement 16 configuré pour calculer un rapport cyclique (duty cycle) de fonctionnement du circuit d'alimentation électrique 12, et notamment un rapport cyclique de commutation dudit au moins un transistor du circuit d'alimentation électrique 12.

En pratique, le rapport cyclique calculé par le deuxième module de traitement 16 peut dépendre de la fréquence de commutation (fréquence de hachage) de l'interrupteur de puissance. En d'autres termes, le rapport cyclique calculé peut varier au cours du temps.

Par exemple, le deuxième module de traitement 16 peut déterminer le rapport cyclique directement à partir du signal de commande issu du premier module de traitement 18, par exemple en mesurant ce signal ou bien en ayant accès aux données utilisées en interne par le premier module de traitement 18 pour générer le signal de commande.

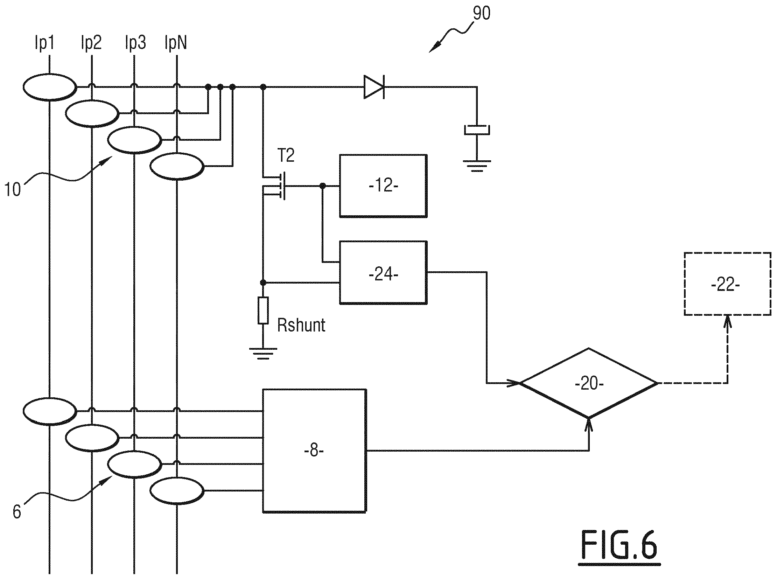

Selon un autre exemple, comme on le verra plus loin en référence à la figure 6, le deuxième module de traitement 16 peut mesurer le courant électrique traversant ledit interrupteur de puissance. Cette mesure peut être réalisée à l'aide d'une résistance de mesure (résistance de shunt) connectée en série avec ledit interrupteur de puissance.

Dans de nombreux modes de réalisation, le premier module de traitement 18 est programmé pour piloter l'interrupteur de puissance afin de maintenir la tension de sortie du circuit d'alimentation électrique 12 régulée à une valeur de tension électrique de référence ou, en variante, à l'intérieur d'un intervalle de tensions de référence.

En d'autres termes, la régulation de la tension de sortie est pilotée par le circuit de traitement 14 (et notamment par premier module de traitement 18). Le circuit de traitement 14 peut implémenter une loi de commande telle qu'une boucle de rétroaction.

Par exemple, la tension de sortie est régulée pour être maintenue à une valeur proche ou égale à 20 Volts. Cet exemple de valeur n'est pas limitatif, et d'autres valeurs de tension de consigne pourraient être choisies en fonction des applications souhaitées.

Le dispositif de diagnostic 2 comporte également un module de diagnostic 20 configuré pour identifier une défaillance d'un capteur à partir du rapport cyclique calculé (ou déterminé) par le deuxième module de traitement 16.

On comprend notamment que ce rapport cyclique calculé par le deuxième module de traitement 16 est une valeur de consigne et qu'il est régulièrement recalculé en fonction des variations de la tension électrique obtenue en sortie du circuit d'alimentation 12.

De préférence, le module de diagnostic 20 est configuré pour comparer le rapport cyclique calculé par le deuxième module de traitement 16 avec un rapport cyclique théorique calculé à partir des valeurs mesurées par les capteurs de courant 6 du premier groupe. Le rapport cyclique théorique peut être calculé par le circuit de traitement 8.

D'autres méthodes peuvent toutefois être utilisées.

Le fonctionnement du module de diagnostic 20 sera décrit plus en détail dans ce qui suit.

Le dispositif de diagnostic 2 comporte également un module d'alerte 22, par exemple configuré pour émettre une alarme lorsque la comparaison effectuée par le module de comparaison 20 conduit à l'identification d'une défaillance d'un ou de plusieurs capteurs de courant 10.

Selon des exemples, le module d'alerte 22 peut être programmé pour activer un indicateur lumineux disposé en façade de l'appareil électrique et/ou pour afficher un message sur une interface homme/machine de l'appareil électrique, cette interface pouvant comporter un écran d'affichage ou un écran tactile. Le module d'alerte 22 peut aussi être configuré pour envoyer un message d'alerte à un appareil distant, par exemple au moyen d'une liaison de télécommunications câblée ou une liaison de télécommunications radio.

Par exemple, le module d'alerte 22 peut comporter ou être connecté à une interface homme/machine, ou à un équipement réseau, ou à un équipement de communication radiofréquence, tel qu'un émetteur/récepteur radio, ou à un concentrateur radio, ou une passerelle réseau, ou à un contrôleur logique programmable, et bien d'autres exemples encore.

Le message d'alerte émis par le module d'alerte 22 peut contenir, outre l'information sur la présence du défaut, une information sur la nature du défaut, voire une information sur l'identification du ou des capteurs de courants 10 qui sont défaillants.

Dans de nombreux modes de réalisation, le circuit de traitement 14 est implémenté par un ou plusieurs circuits électroniques.

Les fonctions de comparaison 20 et d'alerte 22 peuvent aussi être implémentées par des circuits électroniques, par exemple par le même circuit électronique que celui du circuit de traitement 14. En variante, les fonctions de comparaison 20 et d'alerte 22 peuvent être implémentées de façon logicielle.

Le circuit de traitement 8 associé au premier groupe de capteurs de courant 6 peut lui aussi être implémenté par un même dispositif électronique que le circuit de traitement 14.

Selon des exemples de mise en oeuvre, le circuit de traitement 14 comporte un processeur, tel qu'un microcontrôleur programmable ou un microprocesseur. Le processeur est couplé à une mémoire informatique, ou à tout support d'enregistrement de données lisible par ordinateur approprié, qui comporte des instructions exécutables et/ou un code logiciel prévu pour mettre en oeuvre un procédé conforme à l'invention lorsque ces instructions sont exécutées par le processeur.

Selon des variantes, le circuit de traitement 14 peut comporter un processeur de traitement du signal (DSP), ou un composant logique reprogrammable (FPGA), ou un circuit intégré spécialisé (ASIC), ou tout élément équivalent.

D'autres architectures peuvent toutefois être utilisées pour implémenter les modules de traitement 16 et 18.

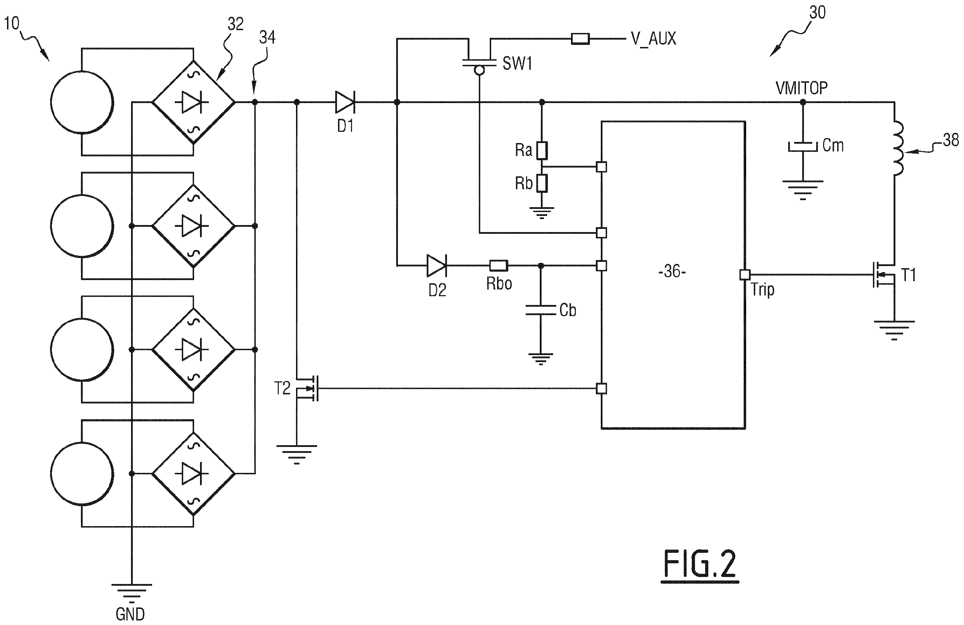

Un exemple d'implémentation du circuit de traitement 14 est illustré à la figure 2.

Dans des modes de réalisation, comme décrit dans ce qui suit, l'appareil électrique peut comporter un circuit électronique de commande, qui porte ici la référence 30.

Dans le mode de réalisation illustré, le circuit électronique de commande 30 est connecté en sortie des capteurs de courant 10. Pour chaque capteur de courant 10, un pont redresseur 32 est connecté en sortie du capteur 10 correspondant. Les sorties respectives des ponts redresseurs 32 sont connectées à un point commun 34.

Par exemple, les ponts redresseurs 32 font partie du circuit d'alimentation électrique 12.

L'interrupteur de puissance précédemment décrit, qui porte ici la référence T2, fait également partie du circuit d'alimentation électrique 12.

L'interrupteur de puissance T2 est connecté entre le point 34 et une masse électrique du circuit 30, qui est ici notée GND.

L'interrupteur de puissance T2 peut être un transistor, tel qu'un transistor à effet de champ. En variante, d'autres technologies pourraient être utilisées, telles qu'un transistor bipolaire, ou un transistor bipolaire à grille isolé (IGBT), ou un relais, et bien d'autres exemples encore.

Dans ce qui suit, l'interrupteur de puissance T2 pourra être nommé « transistor T2 ».

Le circuit électronique de commande 30 comporte également un processeur 36 tel que précédemment expliqué et qui centralise toutes les fonctions de traitement de données de l'appareil électrique.

Par exemple, les fonctionnalités du circuit de traitement 14 et des modules 20 et 22 sont ici implémentées par le circuit 30. Cependant, cet exemple n'est pas limitatif, et d'autres implémentations sont possibles.

En plus, dans l'exemple illustré, le circuit 30 peut implémenter d'autres fonctions, telles que des fonctions de protection, par exemple pour commander l'ouverture de contacts électriques séparables de l'appareil en vue d'interrompre la circulation du courant dans les conducteurs de phase Ip1, Ip2, Ip3 et IpN de l'installation électrique 4. Ces fonctions supplémentaires peuvent toutefois être omises.

Dans de nombreux modes de réalisation, le circuit électronique de commande 30 comporte un conducteur formant un rail d'alimentation connecté au point d'entrée. Ce rail d'alimentation est noté VMITOP sur la figure 2.

Le point commun 34 est raccordé à une sortie du circuit de commande 12, qui est ici raccordée à une entrée du circuit 30.

Une réserve d'énergie Cm, telle qu'un condensateur, est connectée entre le rail d'alimentation et la masse GND. Cette réserve d'énergie Cm peut se charger ou se décharger en fonction de l'évolution de la tension de sortie au fil du temps. Cela permet, par exemple, de contribuer à transformer le courant fourni par les capteurs 10 en une tension d'alimentation lissée.

Dans l'exemple illustré, une diode D1 est connectée sur le rail d'alimentation pour éviter un retour de courant vers le transistor T2 et donc pour éviter de décharger complètement la réserve d'énergie Cm.

L'électrode de commande du transistor T2 est connectée à une première sortie du processeur 36, ce dernier étant ainsi configuré pour commuter le transistor T2 entre ses états passant et bloquant.

De façon générale, le rail d'alimentation est notamment configuré pour alimenter électriquement au moins un ou plusieurs composants de l'appareil électrique, tels que le processeur 36.

Par exemple, comme visible sur la figure 2, un entrée d'alimentation du processeur 36 est connectée audit rail d'alimentation par l'intermédiaire d'une deuxième diode D2, une résistance Rbo et un condensateur Cb.

Plus précisément, dans l'exemple illustré, la résistance Rbo et la diode D2 sont connectées en série entre le rail d'alimentation et l'entrée d'alimentation auxiliaire du processeur 36. Un condensateur Cb est connecté entre la résistance Rbo et la masse GND.

Dans certaines implémentations, comme illustré sur la figure 1, une bobine 38 peut être connectée en série avec un deuxième interrupteur de puissance T1.

La bobine 38 est par exemple une bobine d'un actionneur électromagnétique configuré pour commuter l'appareil électrique, notamment pour déplacer des contacts électriques séparables afin d'interrompre le courant dans les conducteurs de phase.

L'interrupteur de puissance T1 peut être un transistor, tel qu'un transistor à effet de champ. En variante, d'autres technologies pourraient être utilisées, telles qu'un transistor bipolaire, ou un transistor bipolaire à grille isolé (IGBT), ou toute autre technologie appropriée.

L'électrode de commande du transistor T1 est ici raccordée à une autre sortie (notée Trip) du processeur 36 pour commuter le transistor T1 entre ses états passant et bloquant lorsque nécessaire. Dans l'état passant, le transistor T1 permet au courant de passer au travers de la bobine 38.

Toutefois, le transistor T1 et la bobine 38 peuvent être omis lorsque l'appareil électrique n'a pas de fonctions de protection, ou lorsque le contrôle de l'actionneur est réalisé par un circuit de commande distinct du processeur 36.

Dans d'autres implémentations, le circuit 30 peut comporter un circuit d'alimentation auxiliaire comprenant une entrée d'alimentation auxiliaire V_AUX destinée à recevoir une tension électrique d'alimentation fournie par une source d'alimentation extérieure.

Le circuit d'alimentation auxiliaire permet d'alimenter le processeur 36 lorsque les capteurs 10 ne sont pas en mesure de fournir une tension électrique suffisante pour faire fonctionner normalement le processeur 36.

Ainsi, le circuit d'alimentation auxiliaire assure une redondance dans l'alimentation électrique du dispositif 2 et, notamment, dans l'alimentation du processeur 36.

De préférence, le circuit d'alimentation auxiliaire est connecté au rail d'alimentation VMITOP (et donc au processeur 36) par l'intermédiaire d'un interrupteur SW1 piloté par le processeur 36.

Par exemple, lorsqu'un défaut d'alimentation électrique est détecté, le processeur 36 commande la fermeture de l'interrupteur SW1 pour connecter la source d'alimentation extérieure au rail d'alimentation V_AUX (étant entendu que ladite source d'alimentation extérieure est de préférence déconnectée du rail d'alimentation VMITOP lorsque le circuit 20 fonctionne normalement).

L'entrée auxiliaire V_AUX est cependant optionnelle et peut ne pas être connectée à une source d'alimentation électrique, voire peut être omise du dispositif 2. Dans ce cas, le dispositif 2 peut néanmoins comporter un moyen alternatif d'alimentation électrique connecté au transistor 36, tel qu'une pile électrique ou une batterie.

Toutefois, dans de nombreuses implémentations, l'entrée de tension auxiliaire V_AUX et le circuit auxiliaire peuvent être omis.

De façon générale, la tension électrique de sortie entre le rail d'alimentation et la masse GND est régulée, c'est-à-dire est maintenue plus ou moins constante, grâce à l'action du circuit de traitement 14.

Pour ce faire, la tension électrique présente sur le rail d'alimentation est mesurée par le module 14 au moyen d'un système de mesure, tel qu'un un pont diviseur de tension comportant deux résistances Ra et Rb connectées entre le rail d'alimentation et la masse GND.

Par exemple, le processeur 36 est connecté à ce pont diviseur par un de ses terminaux d'entrée.

La tension mesurée au moyen de ce système de mesure peut être convertie en un signal numérique, par exemple au moyen d'un convertisseur analogique numérique, qui ici est intégré au processeur 36, avant d'être traitée par le processeur 36.

En variante, la tension mesurée au moyen de ce système de mesure peut être laissée sous forme analogique, au moins une partie des traitements ultérieurs étant réalisée par des composants électroniques analogiques, tels que des comparateurs.

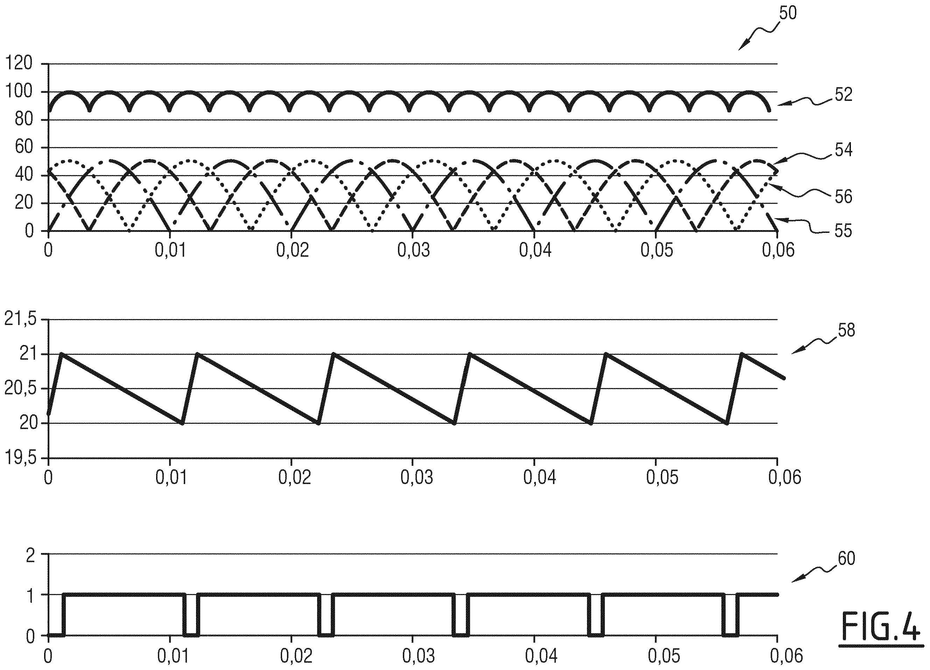

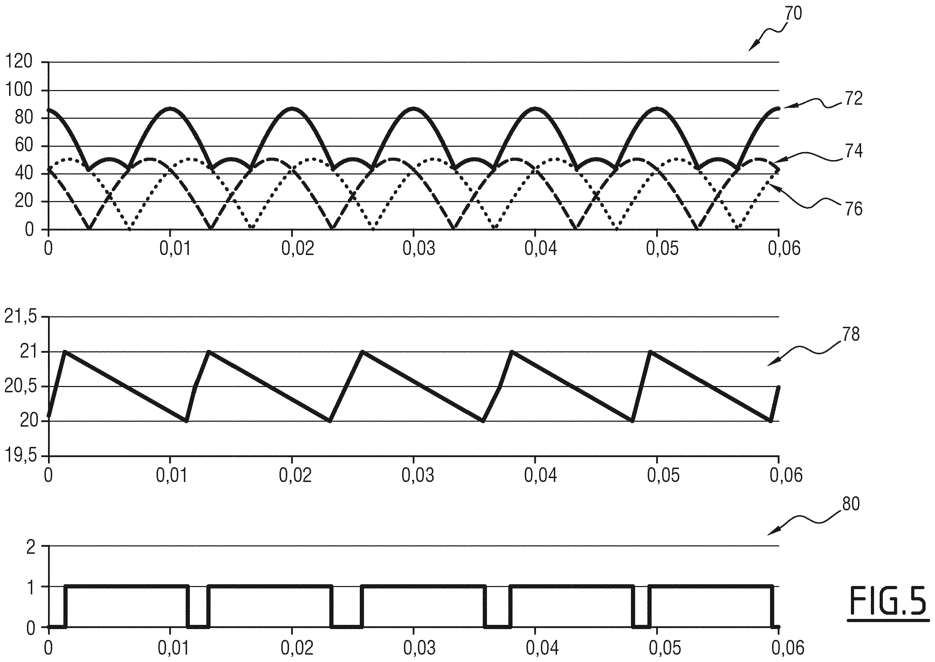

Les figures 4 et 5 représentent l'évolution de grandeurs électriques dans l'appareil 2, respectivement en cas de fonctionnement normal des capteurs de courant 10 et en cas de défaillance d'un des capteurs de courant 10.

Sur la figure 4, le premier graphique 50 représente l'évolution, en fonction du temps (axe des abscisses, échelle libellée en secondes), des courants électriques issus des capteurs de courant 10.

Plus précisément, la courbe 52 correspond au courant électrique mesuré au point 34, résultant de la somme des courants issus de chaque capteur de courant 10.

Les courbes 54, 55 et 56 correspondent respectivement à chacun des courants issus des capteurs de courant 10 associés aux conducteurs de phase Ip1, Ip2 et Ip3 après redressement par le pont redresseur 32.

Comme on peut le constater, dans le cas où le courant de ligne est un courant alternatif sinusoïdal de fréquence 50Hz, les courbes 54, 55 et 56 représentant les phases du courant alternatif triphasé dans les phases Ip1, Ip2 et Ip3 présentent une période de 20 millisecondes et sont déphasées les unes par rapport aux autres d'un angle de phase de 120 degrés. Les trois capteurs de courant 10 associés à ces conducteurs de phase fonctionnent correctement.

La courbe 52, correspondant au courant redressé, présente des valeurs stables et peut éventuellement osciller légèrement (par exemple jusqu'à 10% ou 20% de son amplitude maximale) au sein d'un intervalle de valeurs de courants prédéfinies.

La courbe 58 représente la tension électrique régulée obtenue en sortie du circuit d'alimentation électrique 12.

La courbe 60 représente la forme du signal de commande servant à piloter l'interrupteur de puissance T2.

Par exemple, le signal de commande peut prendre deux valeurs différentes : une première valeur (valeur 0 sur l'axe des ordonnées) pour commuter le transistor T2 dans un état non conducteur, et une deuxième valeur (valeur 1 sur l'axe des ordonnées) pour commuter le transistor T2 dans un état conducteur.

Le signal de commande oscille entre les deux valeurs, par exemple avec une périodicité qui peut varier, la périodicité étant fonction de la valeur des courants électriques issus des capteurs 10. On comprend que le rapport cyclique (par exemple défini comme étant le rapport entre la durée passée pendant chaque période dans la deuxième valeur et la durée totale de la période) choisi par le module de traitement 18 est donc image des courants mesurés par les capteurs 10.

Dans l'exemple illustré, le rapport cyclique est supérieur ou égal à 75% ou à 80%, cet exemple n'étant pas limitatif et d'autres valeurs pouvant être choisies en variante en fonction des circonstances.

Comme visible sur les courbes 58 et 60, lorsque le transistor T2 est dans l'état passant, la tension de sortie diminue, tandis que lorsque le transistor T2 est dans l'état bloquant, la tension de sortie 58 augmente.

Par exemple, la tension de sortie 58 augmente dans l'état bloquant du fait que la réserve d'énergie Cm est en train d'être rechargée. Au contraire, la tension 58 diminue dans l'état passant du fait que la réserve d'énergie Cm se décharge, notamment par le fait qu'une partie de l'énergie stockée est consommée pour alimenter les composants électroniques actifs du dispositif 2, tel que le processeur 36.

Dans cet exemple, du fait de la régulation, la tension 58 reste comprise entre 20 volts et 21 Volts.

La figure 5 représente des courbes similaires du même dispositif 2 dans le cas où l'un des capteurs de courant 10 subit une défaillance et cesse de délivrer un courant électrique.

Dans l'exemple illustré, il s'agit du capteur de courant 10 associé au conducteur de phase Ip2 qui subit une défaillance et ne délivre alors plus aucun courant électrique.

Sur la figure 5, le graphique 70 représente l'évolution, en fonction du temps (axe des abscisses, échelle libellée en secondes), des courants électriques issues des capteurs de courant 10.

Les courbes 72, 74 et 76 du graphique 70 correspondent respectivement aux courbes 52, 54 et 56 du graphique 50 de la figure 4.

En revanche, le graphique 70 ne comporte aucune courbe comparable à la courbe 55, puisque le capteur de courant 10 correspondant a cessé de fonctionner et qu'il ne génère plus aucun courant électrique.

En conséquence, le courant total (courbe 72) présente une amplitude plus faible et les variations d'amplitude sont plus importantes (par exemple jusqu'à 50% ou plus de l'amplitude maximale).

Pour compenser ce changement, tout en continuant à assurer la régulation de la tension électrique de sortie, le module de traitement 18 modifie automatiquement les paramètres de commutation du transistor T2, ce qui se traduit par une modification du rapport cyclique. En effet, on comprend que le rapport cyclique est l'image de la tension de fonctionnement de la régulation asservie sur l'image de la tension du rail d'alimentation VMITOP mesurée au moyen du pont diviseur formé par les résistances Ra et Rb.

Ainsi, comme visible sur les courbes 78 et 80, qui correspondent respectivement aux courbes 58 et 60, le rapport cyclique est diminué pour permettre à la tension de sortie de conserver une forme et des amplitudes proches voire identiques à celles présentées dans la situation normale où les capteurs de courant 10 fonctionnent normalement (courbe 60).

En surveillant le rapport cyclique de commutation du transistor T2 (par exemple sa valeur, ou son évolution dans le temps), il est ainsi possible de détecter l'apparition d'une défaillance d'un capteur de courant 10.

Cet exemple est donné à des fins d'illustration et ne fait pas obstacle à ce que les modes de réalisation de l'invention soient mis en oeuvre pour détecter d'autres types de défaillance d'un capteur de courant, telle qu'une défaillance simultanée de plusieurs capteurs de courant 10, ou un capteur de courant 10 délivrant des valeurs erronées.

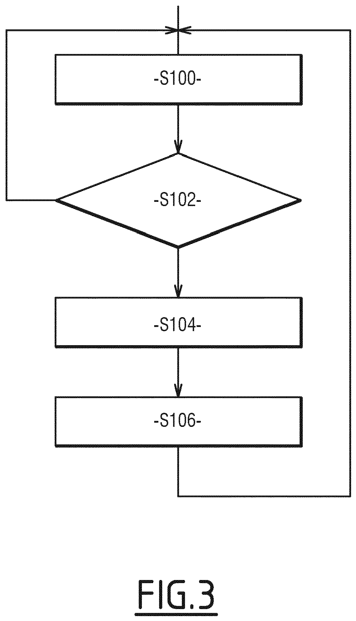

Un exemple de procédé de fonctionnement du dispositif de diagnostic 2 est maintenant décrit en référence à la figure 3.

Initialement, l'appareil électrique fonctionne et tire au moins une partie de son alimentation électrique du courant circulant dans les conducteurs de ligne, grâce aux capteurs de courant 10. Le circuit de contrôle 14 régule la tension électrique de sortie délivrée par le circuit d'alimentation électrique 12 en pilotant le ou les interrupteurs de puissance (T2) avec un signal de commande approprié.

Lors d'une l'étape S100, le dispositif 2 détermine (ici au moyen du deuxième module de traitement 16) automatiquement le rapport cyclique utilisé pour piloter le circuit d'alimentation électrique 12. L'étape S100, de même que le procédé, peut être déclenchée périodiquement.

Lors d'une étape S102, le module 20 analyse le rapport cyclique déterminé pour identifier un défaut provenant de l'un des capteurs de courant 10.

Dans le cas où aucune condition de défaut n'est identifiée, alors le procédé s'arrête jusqu'à la prochaine exécution de l'étape S100.

Dans le cas contraire, une condition de défaut est dite être identifiée.

Par exemple, lors de l'étape S104, un message d'alerte est émis par le module 22.

Optionnellement, lors de l'étape S106, le fonctionnement de tout ou partie de l'appareil électrique peut être interrompu, par exemple en commutant l'appareil électrique dans un état électriquement ouvert, afin d'éviter une situation dans laquelle il ne serait plus en mesure de détecter un défaut électrique dans l'installation. En effet, l'installation électrique 4 ne serait alors plus protégée.

Par exemple, pour ce faire, un ordre de fermeture peut être envoyé au transistor T1 pour alimenter la bobine 38 de l'actionneur et ainsi déclencher l'appareil électrique en ouvrant ses contacts électriques.

En variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

De façon générale, le module de diagnostic 20 peut être configuré de différentes façons pour analyser les données relatives à la commutation de l'interrupteur de puissance (notamment le rapport cyclique de commutation du transistor T2).

Selon une possibilité, l'analyse (étape S100) peut, comme expliqué précédemment, être réalisée directement à partir de l'information sur le rapport cyclique de commutation.

Plus généralement, on peut également utiliser un indice numérique représentatif du rapport cyclique de commutation, telle qu'une valeur moyenne du rapport cyclique de commutation, ou toute autre représentation statistique appropriée.

Par exemple, un indice numérique représentatif de la valeur du rapport cyclique peut être déterminé lors de l'étape S100 par le deuxième module de traitement 16, par exemple en collectant plusieurs échantillons du signal de commande pendant une durée prédéfinie, puis en calculant une valeur moyenne du signal de commande. Ainsi, c'est cet indice numérique qui fait l'objet de l'analyse (de la comparaison) lors de l'étape S102.

La moyenne est réalisée sur un ensemble de valeurs prises sur une durée prédéfinie, par exemple sur une durée correspondant à plusieurs périodes du courant circulant dans les conducteurs de phase.

De plus, comme expliqué précédemment, le rapport cyclique de commutation peut être estimé à partir de grandeurs électriques mesurées, telles que le courant traversant l'interrupteur de puissance, ou l'énergie moyenne prélevée dans la réserve d'énergie Cm.

En ce qui concerne l'analyse mise en oeuvre lors de l'étape S102, il peut être observé que, en général, si un des capteurs de courant 10 est en panne, le courant électrique entrant en entrée du circuit d'alimentation 12 est moindre que quand tous les capteurs de courant 10 fonctionnent normalement. De fait, le condensateur Cm mettra plus de temps pour se recharger, toutes choses étant égales par ailleurs.

Dès lors, le module 18 sera obligé de modifier les paramètres de commutation pour continuer à réguler la tension de sortie à la valeur de consigne prédéfinie. Ce changement se reflète sur la forme du signal de commande et donc sur le rapport cyclique.

Dans certains modes de réalisation, lors de l'analyse, le rapport cyclique peut être comparé à une ou à plusieurs valeurs de référence pour déterminer si un ou plusieurs capteurs de courant 10 ont un comportement anormal révélateur d'un défaut.

En fonction du résultat de la comparaison, une condition de défaut sera identifiée ou non. Par exemple, si le rapport cyclique déterminé est sensiblement différent d'une valeur attendue, alors une condition de défaut sera considérée comme étant identifiée.

La valeur de référence peut, par exemple, être définie en fonction de la quantité de courant électrique que devrait théoriquement recevoir le circuit 12 si les capteurs de courant 10 fonctionnaient normalement.

Les valeurs de référence peuvent être choisies parmi une pluralité de valeurs de référence prédéfinies en fonction de l'amplitude des courants électriques circulant dans les conducteurs de phase.

Par exemple, plusieurs intervalles de courant sont prédéfinis, et à chacun d'eux est associé une valeur de référence. En pratique, lors du fonctionnement, l'amplitude des courants est mesurée par les capteurs de courant 6 ou 10, puis un de ces intervalles est sélectionné en fonction de l'amplitude mesurée, pour obtenir la valeur de référence correspondante.

Ces valeurs de référence peuvent provenir de tables construites à l'avance par le constructeur de l'appareil et correspondant à des conditions de fonctionnement connues, obtenues par exemple par étalonnage, pour un nombre de capteurs de courant 10 donné.

Ces valeurs de référence et/ou ces tables peuvent être enregistrées en mémoire du circuit de traitement 14.

Alternativement, l'analyse peut comporter une analyse de l'évolution du rapport cyclique au cours du temps, par exemple pour détecter une évolution anormale indiquant une modification de la quantité de courant reçue en entrée de l'alimentation 2 par rapport à un historique de valeurs (des valeurs du rapport cyclique pour des instants précédents).

Cette analyse de l'évolution au cours du temps peut être effectuée au moyen d'un filtre à réponse impulsionnelle infinie, ou filtre impulsionnel récursif, implémenté par le dispositif 2.

En variante, analyse de l'évolution au cours du temps peut être réalisée en utilisant un système d'apprentissage par machine, tel qu'un système de classification préalablement paramétré par une phase d'apprentissage.

Ce système peut être implémenté par le dispositif 2, et peut s'appuyer sur une base de données d'apprentissage qui peut être enregistré en mémoire dans le dispositif 2, ou sur une base de données distante accessible par une liaison de communication.

Selon d'autres implémentations, l'analyse peut prendre en compte des valeurs de courant mesurées indépendamment par le premier groupe de capteurs de courant 6, voire en prenant aussi en compte des informations de mesure issues du circuit de traitement 8 et provenant indirectement de ces mêmes capteurs 6.

Par exemple, le module 20 peut être configuré pour comparer le rapport cyclique déterminé par le module 18 à un indice théorique calculé à partir des valeurs de courant mesurées par le premier groupe de capteurs de courant 6.

Par exemple, la détermination de l'indice théorique peut être réalisé à partir de la fabrication de plusieurs produits chacun construit pour être représentatif des aléas de production (produits min / max). Sur chacun de ces produits, des défaillances d'un ou plusieurs capteurs d'alimentation sont forcées ou simulées et l'image du rapport cyclique est enregistrée. De ces enregistrements, un gabarit d'acceptabilité est généré en fonction de la ou des valeurs de courants mesurées. Les appareils pour lesquels le rapport cyclique ne rentre pas dans le gabarit ainsi généré sont considérés comme défaillants et un signal d'alarme est généré.

Cela facilite notamment l'identification du capteur de courant défaillant.

Grâce à l'invention, le dispositif de diagnostic 2 selon les différents modes de réalisation permet de détecter une anomalie de fonctionnement d'un des capteurs de courant 10, qui serait susceptible de compromettre le bon fonctionnement de l'appareil électrique.

Cette détection est implémentée simplement, par exemple en utilisant l'architecture existante de l'appareil électrique (capteurs et circuits de traitement) et en se basant sur des informations qui sont par ailleurs mesurées par le circuit de commande.

La détection est donc plus facile à mettre en oeuvre que si l'on analysait en détail les grandeurs électriques mesurées par chacun des capteurs de courant 10.

Optionnellement, le fait d'avoir recours aux données de mesure issues du premier groupe de capteurs 6 et du circuit de traitement 8 pour effectuer la comparaison permet d'affiner le diagnostic et notamment d'identifier le ou les capteurs de courant 10 qui sont défaillants.

La figure 6 représente un autre mode de réalisation du circuit de la figure 2.

Dans ce nouveau mode de réalisation, le circuit 30 est remplacé par un circuit 90 qui lui est en grande partie analogue voire identique, mais qui diffère du circuit 30 en ce qu'il comporte une résistance de mesure, notée Rₛₕᵤₙₜ, connectée entre le transistor T2 et la masse GND, et un circuit de mesure 24 couplé à la résistance de mesure Rₛₕᵤₙₜ.

Ce circuit de mesure 24 et cette résistance de mesure Rₛₕᵤₙₜ permettent de mesurer le courant électrique qui passe au travers du transistor T2 lorsqu'il est dans l'état passant et ainsi d'obtenir une image du courant total délivré par les capteurs de courant 10 au point de connexion commun 34. Ce courant correspond ici au courant visualisé par les courbes 52 et 72 sur les figures 3 et 4, respectivement.

Dans ce mode de réalisation, le module de diagnostic 20 est programmé pour détecter une condition de défaut en comparant le courant électrique issu des capteurs 10 du deuxième groupe (i.e., les capteurs servant à l'alimentation électrique) avec le courant issu des capteurs de courant 6 du premier groupe (les capteurs de mesure), les valeurs et/ou les formes d'onde du courant issu des capteurs de courant 6 servant alors de référence pour la comparaison.

Ainsi, si le courant issu des capteurs 10 s'écarte du courant de référence issu des capteurs 6 (par exemple, si l'amplitude présente un écart supérieur à un seuil prédéfini par rapport aux valeurs de référence), alors le module de diagnostic 20 identifie cet écart et détermine automatiquement qu'au moins un des capteurs 10 du deuxième groupe présente une défaillance.

Dans certaines variantes, le circuit de mesure 24 peut être intégré au circuit de traitement 8 ou être au moins en partie implémenté par le circuit de traitement 8.

Selon encore un autre mode de réalisation, pouvant être mis en oeuvre indépendamment de tout ou partie des modes de réalisation précédemment décrits, la méthode de détection de défauts basés sur une comparaison du courant issu des capteurs 10 et du courant issu des capteurs 6 peut être utilisée à la place de la méthode précédemment décrite reposant sur l'analyse des rapports cycliques.

En d'autres termes, la condition de défaut est alors détectée non pas à partir des rapports cycliques, mais plutôt uniquement par cette comparaison entre courant issu des capteurs 10 et du courant de référence issu des capteurs 6.

Dans ce cas, un procédé pour identifier un capteur de courant comporte alors des étapes consistant à :
mesurer le courant issu des capteurs de courant 6 du premier groupe de capteurs, pour obtenir une valeur de courant de référence ;
mesurer le courant issu des capteurs de courant 10 du deuxième groupe de capteurs ;
comparer le courant issu des capteurs de courant 10 avec la valeur de référence ;
identifier une condition de défaillance si le courant issu des capteurs de courant 10 s'écarte (par exemple au-delà d'un écart prédéfini) de la valeur de référence.

Ces étapes peuvent être répétées au cours du temps par exemple périodiquement, ou continument.

Toute caractéristique de l'un des modes de réalisation ou variante décrite ci-dessus, peut être mise en oeuvre dans les autres modes de réalisation et variantes décrits.

## Revendications

1. Procédé pour identifier un capteur de courant défaillant dans un appareil électrique, dans lequel l'alimentation électrique de l'appareil électrique est au moins en partie fournie par un circuit d'alimentation électrique à découpage (12) connecté à au moins un capteur de courant (10) qui prélève un courant électrique dans un conducteur de phase d'une installation électrique (4), le circuit d'alimentation délivrant une tension électrique régulée (VMITOP), **caractérisé en ce que** le procédé comporte des étapes consistant à :
- déterminer (S100) un rapport cyclique de commutation d'un interrupteur de puissance de l'alimentation électrique à découpage ;
- analyser (S102) le rapport cyclique de commutation déterminé ;
- identifier (S104) une condition de défaillance si le comportement du rapport cyclique de commutation est représentatif d'une défaillance d'au moins un des capteurs de courant.

2. Procédé selon la revendication 1, dans lequel l'analyse du rapport cyclique de commutation (S102) comporte une comparaison du rapport cyclique de commutation déterminé avec une valeur de référence prédéterminée.

3. Procédé selon la revendication 2, dans lequel la valeur de référence prédéterminée est choisie en fonction de l'amplitude du courant circulant dans les conducteurs de phase.

4. Procédé selon la revendication 1, dans lequel l'analyse (S102) du rapport cyclique de commutation (S102) comporte une analyse de l'évolution du rapport cyclique au cours du temps par rapport à un historique de valeurs passées.

5. Procédé selon la revendication 4, dans lequel analyse de l'évolution au cours du temps est effectuée au moyen d'un filtre à réponse impulsionnelle infinie.

6. Procédé selon la revendication 1, dans lequel l'analyse du rapport cyclique de commutation (S102) comporte une comparaison du rapport cyclique de commutation déterminé avec une valeur théorique du rapport cyclique de comparaison calculée à partir de valeurs de courant mesurées à l'aide d'un ou de plusieurs capteurs de courant additionnels (6).

7. Procédé selon l'une quelconque des revendications précédentes, dans lequel le rapport cyclique déterminé (S100) est une valeur moyenne du rapport cyclique de commutation moyennée sur une durée prédéfinie, par exemple sur une durée correspondant à plusieurs périodes du courant circulant dans les conducteurs de phase.

8. Procédé selon l'une quelconque des revendications précédentes, dans lequel une alerte est automatiquement émise (S104) si une condition de défaut est identifiée.

9. Procédé selon l'une quelconque des revendications précédentes, dans lequel l'appareil électrique est un appareil de protection électrique, tel qu'un disjoncteur, et dans lequel l'appareil est automatiquement déclenché (S106) si une condition de défaut est identifiée.

10. Procédé selon l'une quelconque des revendications précédentes, dans lequel le procédé d'identification d'un capteur défaillant comporte, en outre, des étapes consistant à :
- mesurer la valeur du courant total circulant dans le ou les conducteurs de phase de l'installation électrique (4), au moyen d'un ou de plusieurs capteurs de courant additionnels (6) ;
- mesurer le courant total issu dudit au moins un capteur de courant (10), puis comparer les valeurs de courant total mesuré avec les valeurs de courant mesuré par le ou les capteurs additionnels (6) ;
- identifier une condition de défaillance si l'écart entre les valeurs de courant total issu dudit au moins un capteur de courant (10) et les valeurs de courant mesuré par le ou les capteurs additionnels (6) est supérieur à un seuil prédéfini.

11. Appareil électrique, comportant :
- au moins un capteur de courant (10) adapté pour prélever un courant électrique dans un conducteur de phase d'une installation électrique (4), et
- un circuit d'alimentation électrique à découpage (12) connecté auxdits capteurs de courant et étant configuré pour délivrer une tension électrique régulée pour alimenter l'appareil électrique,
**caractérisé en ce que** l'appareil électrique comporte un dispositif de diagnostic (2) configuré pour mettre en oeuvre des étapes consistant à :
- déterminer (S100) un rapport cyclique de commutation d'un interrupteur de puissance de l'alimentation électrique à découpage ;
- analyser (S102) le rapport cyclique de commutation déterminé ;
- identifier (S104) une condition de défaillance si le comportement du rapport cyclique de commutation est représentatif d'une défaillance d'au moins un des capteurs de courant.

## Patentansprüche

1. Verfahren zum Identifizieren eines defekten Stromsensors in einem elektrischen Gerät, wobei die Stromversorgung des elektrischen Geräts zumindest teilweise durch eine getaktete Stromversorgungsschaltung (12) bereitgestellt wird, die mit mindestens einem Stromsensor (10) verbunden ist, der einen elektrischen Strom in einem Phasenleiter einer elektrischen Anlage (4) abnimmt, wobei die Stromversorgungsschaltung eine geregelte elektrische Spannung (VMITOP) zuführt, **dadurch gekennzeichnet, dass** das Verfahren Schritte umfasst, die aus Folgendem bestehen:
- Bestimmen (S100) eines Schaltzyklusverhältnisses eines Leistungsschalters des Schaltnetzteils;
- Analysieren (S102) des bestimmten Schaltzyklusverhältnisses;
- Identifizieren (S104) eines Fehlerzustands, wenn das Verhalten des Schaltzyklusverhältnisses repräsentativ für einen Fehler von mindestens einem der Stromsensoren ist.

2. Verfahren nach Anspruch 1, wobei die Analyse des Schaltzyklusverhältnisses (S102) einen Vergleich des bestimmten Schaltzyklusverhältnisses mit einem vorbestimmten Referenzwert umfasst.

3. Verfahren nach Anspruch 2, wobei der vorbestimmte Referenzwert abhängig von der Amplitude des in den Phasenleitern fließenden Stroms ausgewählt wird.

4. Verfahren nach Anspruch 1, wobei die Analyse (S102) des Schaltzyklusverhältnisses (S102) eine Analyse der Entwicklung des Schaltzyklusverhältnisses im Lauf der Zeit im Vergleich zu einer Historie vergangener Werte umfasst.

5. Verfahren nach Anspruch 4, wobei die Analyse der Entwicklung über die Zeit mittels eines Filters mit unendlicher Impulsantwort durchgeführt wird.

6. Verfahren nach Anspruch 1, wobei die Analyse des Schaltzyklusverhältnisses (S102) einen Vergleich des bestimmten Schaltzyklusverhältnisses mit einem theoretischen Wert des Vergleichstastverhältnisses umfasst, der aus Stromwerten berechnet wird, die mit einem oder mehreren zusätzlichen Stromsensoren (6) gemessen werden.

7. Verfahren nach einem der vorherigen Ansprüche, wobei das bestimmte Schaltzyklusverhältnis (S100) ein Mittelwert des Schaltzyklusverhältnisses ist, der über eine vordefinierte Zeitdauer gemittelt wird, beispielsweise über eine Zeitdauer, die mehreren Perioden des in den Phasenleitern fließenden Stroms entspricht.

8. Verfahren nach einem der vorherigen Ansprüche, wobei automatisch eine Warnung ausgegeben wird (S104), wenn ein Fehlerzustand identifiziert wird.

9. Verfahren nach einem der vorherigen Ansprüche, wobei das elektrische Gerät ein elektrisches Schutzgerät ist, wie beispielsweise ein Leistungsschalter, und wobei das Gerät automatisch ausgelöst wird (S106), wenn ein Fehlerzustand identifiziert wird.

10. Verfahren nach einem der vorherigen Ansprüche, wobei das Verfahren zum Identifizieren eines defekten Sensors ferner Schritte umfasst, die aus Folgendem bestehen:
- Messen des Werts des Gesamtstroms, der in dem/den Phasenleiter(n) der elektrischen Anlage (4) fließt, mittels eines oder mehrerer zusätzlicher Stromsensoren (6);
- Messen des Gesamtstroms aus dem mindestens einen Stromsensor (10) und anschließendes Vergleichen der gemessenen Gesamtstromwerte mit den Stromwerten, die von dem zusätzlichen Sensor oder den zusätzlichen Sensoren (6) gemessen werden;
- Identifizieren eines Fehlerzustands, wenn die Abweichung zwischen den Werten des Gesamtstroms, der von dem mindestens einen Stromsensor (10) stammt, und den Werten des Stroms, der von dem zusätzlichen Sensor oder den zusätzlichen Sensoren (6) gemessen wird, größer ist als ein vordefinierter Schwellenwert.

11. Elektrisches Gerät, umfassend:
- mindestens einen Stromsensor (10), der angepasst ist, um einen elektrischen Strom in einem Phasenleiter einer elektrischen Anlage (4) zu entnehmen, und
- eine getaktete Stromversorgungsschaltung (12), die mit den Stromsensoren verbunden und konfiguriert ist, um eine geregelte elektrische Spannung zur Versorgung des elektrischen Geräts zuzuführen, **dadurch gekennzeichnet, dass** das elektrische Gerät eine Diagnosevorrichtung (2) umfasst, die konfiguriert ist, um die folgenden Schritte zu implementieren:
- Bestimmen (S100) eines Schaltzyklusverhältnisses eines Leistungsschalters des Schaltnetzteils;
- Analysieren (S102) des bestimmten Schaltzyklusverhältnisses;
- Identifizieren (S104) eines Fehlerzustands, wenn das Verhalten des Schaltzyklusverhältnisses repräsentativ für einen Fehler von mindestens einem der Stromsensoren ist.

## Claims

1. Method for identifying a faulty current sensor in an electrical appliance, in which the electrical supply to the electrical appliance is at least partly provided by a switched-mode power supply circuit (12) connected to at least one current sensor (10) which draws an electric current from a phase conductor of an electrical installation (4), the supply circuit supplying a regulated electric voltage (VMITOP), **characterised in that** the method comprises the steps of:
- determining (S100) a switching duty cycle of a power switch of the switch mode power supply;
- analyse (S102) the determined switching duty cycle;
- identify (S104) a failure condition if the switching duty cycle behaviour is indicative of a failure of at least one of the current sensors.

2. The method according to claim 1, wherein the analysis of the switching duty cycle (S102) comprises a comparison of the determined switching duty cycle with a predetermined reference value.

3. A method according to claim 2, wherein the predetermined reference value is selected in accordance with the magnitude of the current flowing in the phase conductors.

4. A method according to claim 1, wherein the analysis (S102) of the switching duty cycle (S102) comprises an analysis of the evolution of the duty cycle over time with respect to a history of past values.

5. A method according to claim 4, wherein time course analysis is performed using an infinite impulse response filter.

6. Method according to claim 1, wherein the analysis of the switching duty cycle (S102) comprises a comparison of the determined switching duty cycle with a theoretical value of the comparison duty cycle calculated from current values measured with one or more additional current sensors (6).

7. Method according to any of the preceding claims, wherein the determined duty cycle (S100) is an average value of the switching duty cycle averaged over a predefined time period, for example over a time period corresponding to several periods of the current flowing in the phase conductors.

8. Method according to any of the preceding claims, wherein an alert is automatically issued (S104) if a fault condition is identified.

9. Method according to any of the preceding claims, wherein the electrical apparatus is an electrical protection apparatus, such as a circuit breaker, and wherein the apparatus is automatically tripped (S106) if a fault condition is identified.

10. Method according to any one of the preceding claims, wherein the method of identifying a faulty sensor further comprises steps of:
- measuring the value of the total current flowing in the phase conductor(s) of the electrical installation (4), by means of one or more additional current sensors (6);
- measuring the total current from the at least one current sensor (10), and then compare the measured total current values with the current values measured by the additional sensor(s) (6);
- identifying a fault condition if the difference between the total current values from the at least one current sensor (10) and the current values measured by the additional sensor(s) (6) is greater than a predefined threshold.

11. Electrical apparatus, comprising:
- at least one current sensor (10) adapted to draw an electrical current from a phase conductor of an electrical installation (4), and
- a switching power supply circuit (12) connected to said current sensors and being configured to supply a regulated voltage to power the electrical apparatus, **characterised in that** the electrical apparatus comprises a diagnostic device (2) configured to implement steps of:
- determining (S100) a switching duty cycle of a power switch of the switch mode power supply;
- analyse (S102) the determined switching duty cycle;
- identify (S104) a failure condition if the switching duty cycle behaviour is indicative of a failure of at least one of the current sensors.
